# EUROPÄISCHE PATENTSCHRIFT

(11) **EP 3 447 804 B1**
(45) Veröffentlichungstag und Bekanntmachung des Hinweises auf die Patenterteilung: **16.02.2022**
(21) Anmeldenummer: 17187982.8
(22) Anmeldetag: 25.08.2017
(51) Int. Cl.: H01L 31/05

(54) **SOLARZELLENVERBINDER MIT FUNKTIONELLER LÄNGSBESCHICHTUNG**
SOLAR CELL CONNECTOR WITH FUNCTIONAL LONGITUDINAL COATING
CONNECTEUR DE CELLULES SOLAIRES DOTÉ D'UNE COUCHE LONGITUDINALE FONCTIONNELLE

(43) Veröffentlichungstag der Anmeldung: 27.02.2019
(73) Patentinhaber: Heraeus Deutschland GmbH & Co. KG, 63450 Hanau (DE)
(72) Erfinder: Henning, Andreas, 36391 Sinntal-Mottgers (DE); Koenig, Markus, 64807 Dieburg (DE)
(74) Vertreter: Heraeus IP

(56) Entgegenhaltungen:
- WO-A1-2006/128204
- WO-A1-2012/111185
- US-A1- 2014 246 068

## Beschreibung

Die vorliegende Erfindung betrifft einen Verbinder zum Verbinden einer Solarzellenelektrode mit einem weiteren Element sowie ein Verfahren zu dessen Herstellung und ein Photovoltaikbauteil, in welchem der Verbinder verwendet wird.

Eine Solarzelle besteht typischer Weise mindestens aus einer Halbleiterschicht, die von mindestens zwei Elektroden unterschiedlicher Polarität kontaktiert wird. Die Halbleiterschicht ist in den meisten Fällen eine dotierte Siliziumschicht, die in Form eines monokristallinen oder multikristallinen Silizium-Wafers vorliegt. Üblicher Weise befinden sich die unterschiedlich gepolten Elektroden auf entgegengesetzten Seiten der Halbleiterschicht. Wenn Licht auf die Solarzelle trifft, kommt es zu einer Ladungstrennung in der Halbleiterschicht und die Ladungen können als Strom an den Elektroden abgegriffen werden. Um auf der gesamten Fläche der Halbleiterschicht effizient Ladungen einzusammeln, befinden sich auf der lichteinfallenden Seite eine Vielzahl dünner Elektroden, die die Halbleiterschicht wie ein dünnes Netzt überspannen. Diese dünnen Elektroden auf der lichteinfallenden Seite werden auch Fingerelektroden genannt. Gewöhnlich sind die Fingerelektroden sehr dünn, damit möglichst wenig Fläche der Halbleiterschicht abgeschattet wird. Häufig weisen die Fingerelektroden eine Breite im Bereich von 20 - 150 µm auf.

Um die von den Fingerelektroden eingesammelten Ladungsträger effizient abzuleiten, sind die Fingerelektroden mit einem oder mehreren Busbars verbunden. Die Busbars haben einen höheren Leitungsquerschnitt als die Fingerelektroden und sind mechanisch robuster als die Fingerelektroden. Auf Grund ihrer höheren Fläche und der mechanischen Robustheit werden Sie unter anderem als Kontaktflächen zum Anschließen der Solarzellen genutzt. Busbars haben typischer Weise eine Breite im Bereich von 0,1 bis 2 mm. Eine Solarzelle kann einen oder mehrere Busbars aufweisen. Um höhere Spannungen abgreifen zu können, werden mehrere Solarzellen in Reihe geschaltete und dadurch zu Photovoltaikmodulen verbunden. Um mehrere Solarzellen zu Photovoltaikmodulen zu verschalten, werden die Solarzellenelektroden benachbarter Solarzellen mit einem Verbinder verbunden.

Der Verbinder ist typischer Weise ein Metallband, insbesondere ein Kupferband. Die Kontaktierung der Solarzellenelektroden, insbesondere der Busbars, erfolgt meistens durch Löten. Dazu wird ein Kupferband, z.B. durch Tauchbeschichtung, vollständig mit einer dünnen Schicht einer Lotlegierung beschichtet und dieses beschichtete Kupferband wird anschließend mit den Elektroden von zwei Solarzellen durch Erhitzen verlötet. In dem am häufigsten verwendeten Szenario verbindet ein Verbinder die Frontseitenelektrode einer ersten Solarzelle mit der Rückseitenelektrode einer weiteren Solarzelle, wobei Front- und Rückseitenelektrode unterschiedliche Polaritäten aufweisen. Um eine lange Lebensdauer der Photovoltaikmodule zu gewährleisten, ist es wünschenswert, dass der Kontakt zwischen Verbinder und Solarzellenelektrode eine hohe mechanische Festigkeit und eine hohe elektrische Leitfähigkeit aufweist. Ein Verbinder kontaktiert meist einen mechanisch robusten Busbar, wobei der Busbar wiederum eine Vielzahl von Fingerelektroden kontaktiert. Busbar und Verbinder werden typischer Weise durch Löten miteinander verbunden.

Documen US 2014/246068 A1 offenbart einen Metallverbinder zum elektrischen Verbinden von Rückseitensolarzellen. Der Metallverbinder ist partiell mit einer isolierenden Schicht, z.B. einer Keramikschicht beschichtet. Die freie, d.h. nicht mit Isolator beschichtete, Fläche des metallischen Teils eine galvanisch aufgetragene Silberbeschichtung aufweist, die die Lötfähigkeit verbessern kann. Um eine möglichst geringe Abschattung der aktiven Halbleiterschicht der Solarzelle zu erreichen, geht die Entwicklung hin zu immer mehr und immer dünneren Busbars. Wenn Verbinder und Busbar gleich breit sind, kann es bei konventionellen, vollständig mit Lotlegierung beschichteten Verbindern passieren, dass beim Lötprozess flüssiges Lot über den Busbar hinaus fließt und zusätzlich eine oder mehrere Fingerelektroden benetzt. Beim Kontakt mit der flüssigen Lotlegierung kann eine Fingerelektrode chemisch und mechanisch beschädigt werden. Zum Beispiel kann es durchdurch Korrosion zu einer Verminderung der Leitfähigkeit kommen oder zu einer kompletten Unterbrechung des Kontakts. Dies führt dazu, dass eingesammelte elektrische Ladungen schlechter oder gar nicht aus dem Bereich des unterbrochenen Fingers abtransportiert werden können und im Endeffekt die Effizienz der Solarzelle reduziert wird. Selbst wenn die Fingerelektrode nicht direkt beim Kontakt mit der Lötlegierung beschädigt wird, steigt die Wahrscheinlichkeit, dass die überlötete Fingerelektrode infolge thermischer Wechselbelastung auf Grund von Korrosion über die Lebensdauer der Solarzelle unterbrochen wird. Daher ist es wünschenswert, dieses Überlöten der Fingerelektroden während der Herstellung zu verhindern.

Die Aufgabe der vorliegenden Erfindung war es, einen Verbinder bereitzustellen, der Nachteile des Stands der Technik überwindet und insbesondere einen Verbinder bereitzustellen, der ein Überlöten der Fingerelektroden verhindert, wenn ein Busbar verwendet wird, der eine gleiche oder ähnliche Breite aufweisen wie der Verbinder. Dies ist vor allem bei dem aktuell zu beobachtenden Trend der Steigerung der Anzahl der Busbars pro Zelle und gleichzeitiger Reduzierung der Busbarbreite von zunehmender Bedeutung.

Eine weitere Aufgabe war es, ein einfaches Verfahren zur Herstellung des erfindungsgemäßen Verbinders bereitzustellen.

Bevorzugt löst, die Erfindung zusätzlich die Aufgabe Lotmaterial zu sparen, gegenüber einem vollständig mit Lot beschichteten Verbinder.

Die Aufgaben werden gelöst durch einen Verbinder zum Verbinden einer ersten Solarzellenelektrode mit einem weiteren Element, wobei der Verbinder eine metallische Leiterstruktur aufweist und die Leiterstruktur entlang ihres Umfangs abwechselnd umlaufend mit jeweils zwei durchgängigen Bereichen von Materialien A und B beschichtet ist, wobei A ein Lotmaterial und B ein dielektrisches Material ist, dadurch gekennzeichnet, dass die Fläche jeder Orthogonalprojektion des gesamten Verbinders mindestens 10% größer ist als die Fläche der Orthogonalprojektion von jedem der Bereiche von Material A. Bevorzugt kann der erfindungsgemäße Verbinder also als mit jeweils zwei voneinander getrennten Streifen von Material A und B entlang der Hauptrichtung beschichtete Leiterstruktur verstanden werden.

Im Rahmen der vorliegenden Erfindung wurde erkannt, dass der erfindungsgemäße Verbinder besonders gut eine Beschädigung der Fingerelektroden beim Lötprozesse verringern oder vermeiden kann und damit zum Verbinden von Solarzellenelektroden, z.B. Busbars mit geringer Breite, geeignet ist.

Bevorzugt ist die Leiterstruktur symmetrisch mit den entlang ihres Umfangs abwechselnd Bereichen von Materialien A und B beschichtet. Symmetrisch meint in diesen Zusammenhang, dass jeweils die Bereiche von Material A und B auf gegenüberliegenden Seiten der Leiterstruktur angeordnet sind. Durch eine symmetrische Beschichtung hat der Verbinder im Herstellungsprozess keine Vorzugsausrichtung, da er eine Solarzellenelektrode mit beiden Seiten, insbesondere oben und unten, kontaktieren kann. Somit kann die Handhabung des Verbinders während des Herstellungsverfahrens eines Photovoltaikmoduls vereinfacht werden.

Ein weiterer Vorteil der erfindungsgemäßen Verbinder ist, dass das Lotmaterial A beim Lötprozess nicht mit den Fingerelektroden in Kontakt kommen kann und so ein Überlöten verhindert werden kann.

### Definitionen

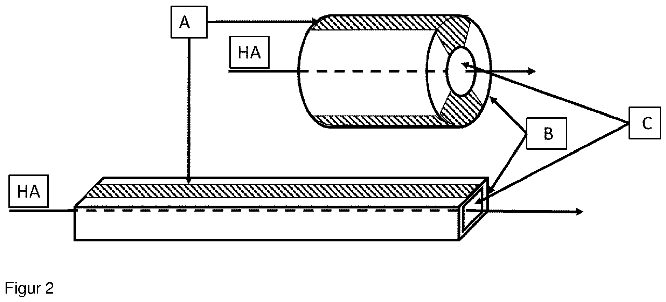

Hauptachse: Unter der Hauptachse der Leiterstruktur ist im Rahmen der Erfindung die Achse entlang der längsten Ausdehnungsrichtung der Leiterstruktur zu verstehen. Typischer Weise ist die Hauptachse identisch mit der Hauptflussrichtung des Stroms. Beispielhafte Ausgestaltungen einer Hauptachse (HA) sind in Figur 2 als Pfeile durch die Leiterstrukturen (C) dargestellt.

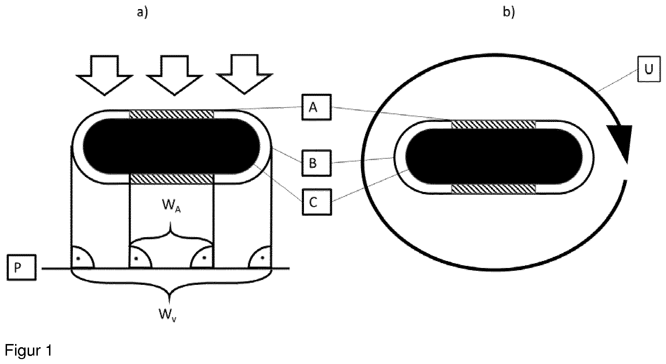

Umfang: Unter dem Umfang der Leiterstruktur ist eine gedachte Linie zu verstehen, die entlang er Oberfläche der Leiterstruktur verläuft, wobei jeder Punkt auf dieser Linie senkrecht über demselben Punkt auf der Hauptachse steht. Der Verlauf des Umfangs ist beispielhaft anhand des gebogenen Pfeils (U) in Figur 1b) dargestellt, wobei ein erfindungsgemäßer Verbinder im Querschnitt dargestellt ist.

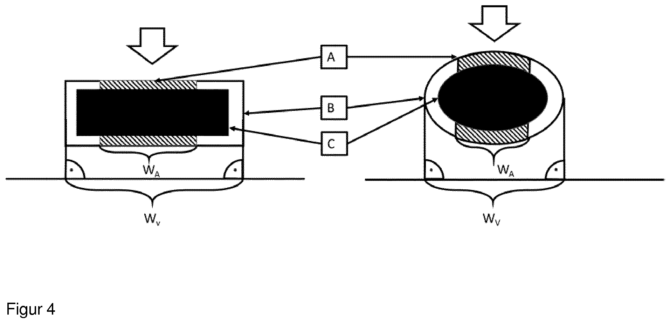

Orthogonalprojektion: Unter der Orthonalprojektion ist eine Abbildung eines dreidimensionalen Körpers auf eine zweidimensionale Projektionsebene zu verstehen, die dadurch erreicht wird, dass jeder Punkt des Körpers, bezogen auf die Projektionsebene, senkrecht auf dieser Ebene abgebildet wird. Der Begriff Orthogonalprojektion wird synonym zu "senkrechte Parallelprojektion" verwendet. Eine beispielhafte Orthogonalprojektion ist in Figur 1a) an einem Querschnitt durch den Verbinder dargestellt. Die dicken Pfeile in Figur 1a) zeigen die Projektionsrichtung an. In Figur 1 a) und b) sind A: Schicht aus Material A, B: Schicht aus Material B, C: Leiterstruktur, Wv: Orthogonalprojektion des Verbinders (in 2D), W_{A}: Orthogonalprojektion der Schicht von Material A (in 2D) und P: Projektionsfläche. Die Bezeichnungen A, B, C, W_{V}, W_{A} gelten durchgängig für alle Zeichnungen. In Figur 1 ist zu erkennen, dass Wv größer ist als W_{A}. Die oben genannte Bedingung für die Orthoganlprojektionen W_{V} und W_{A} gilt bevorzugt unabhängig von der Form des Querschnitts des Verbinders. Figur 4 a) und b) zeigt weitere beispielhafte Orthogonalprojektionen von Verbindern mit rechteckigem und elliptischem Querschnitt.

Die vorliegende Erfindung betrifft einen Verbinder zum Verbinden einer ersten Solarzellenelektrode, insbesondere eines Busbars, mit einem weiteren Element. Bevorzugt ist das weitere Element eine Solarzellenelektrode einer weiteren Solarzelle oder eine Anschlussleitung für ein Photovoltaikmodul. Vorzugsweise wird der erfindungsgemäße Verbinder verwendet, um mehrere Solarzellen in Reihe zu schalten.

Eine Solarzelle enthält mindestens: eine Halbleiterschicht, eine positive Solarzellenelektrode (Kathode) und eine negative Solarzellenelektrode (Anode). Im Rahmen der Erfindung ist eine Solarzellenelektrode immer auf einer Solarzelle angeordnet. Positive und negative Elektrode sind bevorzugt auf unterschiedlichen Seiten der Halbleiterschicht angeordnet. Die Elektroden unterschiedlicher Polarität können alternativ auch auf derselben Seite der Halbleiterschicht angeordnet sein (sogenannte *back contact cells*). Bevorzugt verbindet der Verbinder die positive Solarzellenelektrode einer ersten Solarzelle mit der negativen Solarzellenelektrode einer weiteren Solarzelle. Der Verbinder weist bevorzugt einen hohen Leitungsquerschnitt und eine hohe Leitfähigkeit auf, um Strom effizient von den Solarzellenelektroden, insbesondere den Busbars, abzuleiten. Weiterhin können Verbinder eine mechanisch und elektrisch stabile Verbindung zwischen den Elektroden der Solarzellen herstellen. Dies kann durch den erfindungsgemäßen Verbinder erreicht werden, indem der Verbinder ein Lotmaterial umfasst.

Der Verbinder umfasst eine metallische Leiterstruktur. Die Leiterstruktur enthält bevorzugt Kupfer oder besteht aus Kupfer. Wenn die Leiterstruktur aus Kupfer besteht, bedeutet dies, dass die Leiterstruktur mindestens 99,90 Gewichts-% Kupfer aufweist. In einer bevorzugten Ausführung kann die Leiterstruktur aus Kupfer hergestellt sein, dass den Industriestandards Cu-ETP oder Cu-OFC genügt.

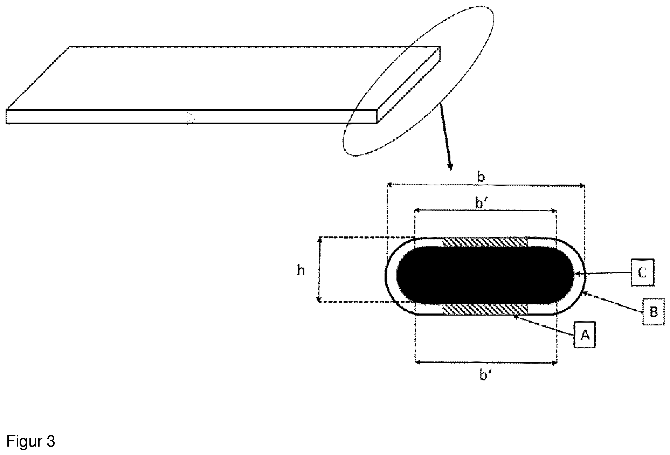

Die metallische Leiterstruktur kann ein Metallband oder ein Metalldraht sein. Bevorzugt ist die metallische Leiterstruktur ein Band, insbesondere ein Kupferband. Der Metalldraht weist bevorzugt einen sphärischen, elliptischen oder quadratischen Querschnitt auf. Bevorzugt weist das Seitenverhältnis des Querschnitts des Drahtes ein Verhältnis von 0,8-1,2 auf. Das Seitenverhältnis ist der Quotient aus Länge und Breite des Querschnitts der Leiterstruktur. Das Metallband weist bevorzugt einen rechteckigen oder annähernd rechteckigen Querschnitt auf. Bei einem annähernd rechteckigen Querschnitt kann die breite Seite b am Metallband oben und unten zueinander parallel stehende Flächen b' aufweisen, während die kurze Seite h partiell oder vollständig abgerundet sein kann. Ein Beispiel für eine abgerundete Seite h ist in Figur 3 dargestellt. Ein Querschnitt des Metallbandes mit parallelen breiten Seiten b' und abgerundeten Seiten h kann beispielsweiße erhalten werden, indem ein Runddraht flach gewalzt wird. Die Breite b des Metallbands ist bevorzugt mindestens doppelt so lang wie die Höhe h. Die bevorzugte Seitenlänge der kürzeren Seite h liegt im Bereich von 0,1 mm - 0,4 mm, insbesondere im Bereich von 0,16 mm - 0,3 mm. Die Seitenlänge der langen Seiten b liegt bevorzugt im Bereich von 0,6 - 2,0 mm, insbesondere im Bereich von 0,9 mm - 1,5 mm. Die metallische Leiterstruktur weist eine Hauptachse (HA) entlang ihrer längsten Ausdehnungsrichtung auf (beispielhaft dargestellt durch Pfeile durch die Leiterstruktur in Abbildung 2). In einer bevorzugten Ausführung verläuft die Hauptachse entlang der Stromrichtung.

Die Länge der Leiterstruktur entlang der Hauptachse ist nicht weiter beschränkt. Bevorzugt weist die Leiterstruktur eine Länge auf, die ausreicht um zwei nebeneinander positionierte Solarzellen über ihre Elektroden, insbesondere über ihre Busbars, miteinander zu verbinden. Dabei kann die Länge der Leiterstruktur beispielsweise doppelt so lang sein, wie die Länge einer zu verbindenden Solarzelle. Insbesondere liegt die Länge der Leiterstruktur im Bereich von 100 - 600 mm und ganz besonders bevorzugt im Bereich von 200 - 400 mm.

Die metallische Leiterstruktur weist bevorzugt mindestens eine der folgenden mechanischen Eigenschaften auf:
- Eine Zugspannung Rm im Bereich von 100 - 300 MPa, bevorzugt maximal 280 MPa.
- Eine Streckgrenze Rp0,2 im Bereich von 40 - 120 MP, bevorzugt maximal 80 MPa
- Eine Bruchdehnung A100 im Bereich von 10 - 40%, bevorzugt minimal 25%

Optional kann die Leiterstruktur auch mehrere oder alle der genannten mechanischen Eigenschaften aufweisen.

Die Leiterstruktur ist entlang ihres Umfangs (also um die Hauptachse herum) abwechselnd mit jeweils zwei durchgängigen Bereichen von Materialien A und B beschichtet. Die entlang ihres Umfangs abwechselnden Bereiche können bevorzugt auch als Streifen entlang der Hauptachse der Leiterstruktur verstanden werden. In einer bevorzugten Ausführung können die Streifen gerade oder spiralförmig entlang der Oberfläche der Leiterstruktur verlaufen. Bevorzugt beschichten die Materialien A und B die Leiterstruktur entlang der Hauptrichtung so vollständig, dass keine Lücken zwischen den jeweils mit Material A und Material B beschichteten Bereichen vorliegen, d.h. die Oberfläche der Leiterstruktur ist, zumindest entlang der Hauptachse, vollständig bedeckt und nicht direkt zugänglich. An ihren Enden kann die Leiterstruktur, insbesondere das Metallband oder der Metalldraht, entweder mit Material A oder Material B beschichtet sein oder frei von Beschichtung sein. Durch die entlang des Umfangs umlaufende Beschichtung ist die gesamte Oberfläche der Leiterstruktur vorzugsweise entweder mit Material A oder Material B bedeckt. In einer besonders bevorzugten Ausführung kann Material A das Material B teilweise überlappen. Durch die entlang des Umfangs abwechselnde, umlaufende Beschichtung ist die Leiterstruktur bevorzugt besonders gut gegen Umwelteinflüsse geschützt, die zu Korrosion der Leiterstruktur führen können. Dadurch kann ein besonders alterungsresistenter elektrischer Kontakt zwischen dem Verbinder und einer Solarzellenelektrode erreicht werden.

Material A ist ein Lotmaterial. Die Begriffe Material A, Lotmaterial A und Lotmaterial werden in dieser Anmeldung synonym verwendet. Bevorzugt enthält das Lotmaterial eine Lotlegierung oder besteht aus einer Lotlegierung. Eine Lotlegierung ist ein metallisches Gemisch aus Elementen, von denen mindestens eines ein Metall ist. Bevorzugt sind alle Elemente der Legierung Metalle. Bevorzugt weist die Lotlegierung einen Schmelzpunkt auf, der mindestens 100°C, insbesondere mindestens 200°C, unter der Schmelztemperatur der Leiterstruktur liegt. Bevorzugte Lotlegierungen enthalten Element, die ausgewählt sind aus der Gruppe bestehend aus, Sn, Pb, Ag, Bi, Cu, Zn, Au, Sb, Cd, Co und Al. Bevorzugt besteht die Lotlegierung aus mindestens zwei dieser Elemente. Besonders bevorzugte Lotlegierungen sind ausgewählt aus der Gruppe enthaltend SnPb, SnPbAg, SnPbBi, SnAg, SnAgBi, SnAgCu, SnBi und SnCu. Die Lotlegierung kann ausgewählt sein aus bleihaltigen Lotlegierungen und bleifreien Lotlegierungen. Besonders bevorzugte bleihaltige Lotlegierungen sind ausgewählt aus der Gruppe bestehend aus Sn₆₂Pb₃₆Ag₂, Sn₆₃Pb₃₇ und Sn₆₀Pb₄₀. Besonders bevorzugte bleifreie Lotlegierungen sind ausgewählt aus der Gruppe bestehend aus Sn_{96,5}Ag_{3,5}, Sn_{96,5}Ag₃Cu_{0,5}, Sn₆₀Bi₄₀, Sn₅₀Bi₄₈Ag₂, Sn₄₂Bi₅₇Ag₁, Sn₄₃Bi₅₇, Sn₅₀Bi₅₀ und Sn99,3Cu_{0,7}. Das Lotmaterial kann bis auf unvermeidliche Verunreinigungen aus der Lotlegierung bestehen. Bevorzugt beträgt die Gesamtmenge der Bestandteile, die nicht der Lotlegierung zugerechnet werden können, nicht mehr als 0,1 Gew.-%, insbesondere nicht mehr als 0,01 Gew.-%.

Alternativ kann das Lotmaterial eine Lotlegierung enthalten, wobei das Lotmaterial zusätzlich andere Bestandteile enthält. Das Lotmaterial kann beispielsweise Flussmittel, Lösungsmittel sowie andere Additiven aufweisen. Das Flussmittel ist bevorzugt ausgewählt aus organischen Säuren, wie z.B. Kolophonium oder Adipinsäure, anorganischen Salzen, wie z.B. Ammoniumchlorid, anorganische Säuren, wie z.B. Phosphorsäure. Bevorzugt sind die Flussmittel frei von Halogeniden. Bevorzugt ist das Lösungsmittel ein organisches oder wässriges Lösungsmittel. Die Additive sind bevorzugt Aktivatoren. Bekannte Aktivatoren sind z.B. halogenidhaltige Verbindungen. Bevorzugt liegt der Anteil an den genannten anderen Bestandteilen des Lotmaterials (z.B. Flussmittel, Lösungsmittel und Aktivatoren) im Bereich von 1 Gew.-% oder weniger, insbesondere 0,1 Gew.-% oder weniger. Die anderen Bestandteile im Lotmaterial können in einer bevorzugten Ausführung Rückstände einer Lotpaste sein, wie sie im Verfahren zur Herstellung des erfindungsgemäßen Verbinders beschrieben ist.

Die Schichtdicke der entlang ihres Umfangs abwechselnden Bereiche von Material A liegt bevorzugt im Bereich von 1 µm - 40 µm und besonders bevorzugt im Bereich von 10 µm - 20 µm.

Material B ist ein dielektrisches Material. Bevorzugt umfasst Material B ein Polymermaterial oder eine Keramik. Insbesondere besteht Material B aus einem Polymermaterial oder einer Keramik. Insbesondere ist Material B so ausgewählt, dass es nicht von geschmolzener Lotlegierung, wie sie für Material A zum Einsatz kommt, benetzt wird. Das Polymermaterial kann ein Homopolymer oder ein Copolymer enthalten. Das Polymermaterial kann duroplastische oder thermoplastische Eigenschaften aufweisen. Unter duroplastischen Materialien werden allgemein solche verstanden, die sich bei Erwärmung nicht verformen lassen. Besonders bevorzugt ist das Polymermaterial ein duroplastisches Material. Duroplasten werden bevorzugt durch chemisches Vernetzen von Harzen, insbesondere Kunstharzen und Naturharzen hergestellt. Bevorzugt sind die Kunstharze ausgewählt aus Epoxid-Harzen, PolyesterHarzen und Acrylat-Harzen. Das Harz kann ein Ein-oder Mehr-Komponenten-System sein. Das Aushärten bzw. Vernetzten des Harzes wird bevorzugt durch UV-Licht, Wärme oder durch Zugabe einer weiteren Komponente initiiert. Die weitere Komponente kann z.B. ein Vernetzer, ein Katalysator oder ein Initiator sein. Besonders bevorzugt ist das Polymermaterial ein vernetzter Lack, wie z.B. ein Lotstopplack. Ein Lotstopplack kann in den Bereichen, in denen er aufgetragen ist, das Benetzen der Oberfläche der Leiterstruktur mit geschmolzener Lotlegierung verhindern. Der Lotstopplack kann bevorzugt ein ausgehärtetes, insbesondere vernetztes, Epoxid-Harz enthalten. Ganz besonders bevorzugt ist das Polymermaterial, das als Material B eingesetzt wird, UV-gehärtet, d.h. das verwendete Harz vernetzt unter Einwirkung von UV-Licht (Wellenlänge ca. 200 - 400 nm) aus.

In einer bevorzugten Ausführungsform weist das Material B ein Elastizitätsmodul von 7 GPa oder weniger, insbesondere 5 GPa oder weniger und besonders bevorzugt 2 GPa oder weniger auf. Der Anteil der Beschichtung mit Material B an der gesamten Oberfläche der Leiterstruktur ist bevorzugt 5 - 95%, und bevorzugt 30 - 80% der gesamten Fläche des Verbinders. In einer bevorzugten Ausführungsform umfasst das Polymermaterial mindestens einen Füllstoff. Der mindestens eine Füllstoff kann ein organischer oder anorganischer Füllstoff sein. Insbesondere kann der Füllstoff in Form von Partikeln vorliegen. Der anorganische Füllstoff kann beispielsweise ein Metalloxid sein, das aus der Gruppe bestehend aus TiO₂, ZnO, SiO₂, ZrO₂, SnO₂, CaO und Al₂O₃ ausgewählt ist. Bevorzugt weist der Füllstoff lichtstreuende Eigenschaften auf. Bevorzugt liegt der Füllstoff als in dem Polymermaterial verteilte Partikel vor. Da Material B ein dielektrisches Material ist, wirkt es als Isolator. Dabei bezieht sich die Isolatorwirkung auf die Schicht aus Material B als Ganzes. Es ist erfindungsgemäß nicht ausgeschlossen, dass das Material B, in Form eines Polymermaterials, als Füllstoff metallische Partikel umfasst. Bevorzugt wird der Füllgrad der metallischen Partikeln im Polymermaterial so gering gehalten, dass die Schicht des Polymermaterials als Ganzes keine erhöhte elektrische Leitfähigkeit gegenüber einem ungefüllten Polymermaterial aufweist. Bevorzugt streuen die metallischen Partikel das sichtbare Licht, insbesondere das auf den Verbinder einfallende Sonnenlicht und schmelzen auch bevorzugt nicht bei Löttemperatur des Lotmaterials.

Wenn das Material B, insbesondere das Polymermaterial, einen lichtstreuende Füllstoff enthält, kann Sonnenlicht, das auf den Verbinder einfällt, so gestreut werden, dass es die Solarzelle bzw. das daraus gefertigte Photovoltaikmodul nicht wieder verlässt, sondern durch interne Reflektion in die aktive Halbleiterschicht gelangt und dort zusätzliche Ladungsträger generiert. Dadurch kann der Wirkungsgrad der Solarzelle erhöht werden.

Die Schichtdicke der Schicht aus Material B liegt bevorzugt im Bereich von 1 µm-40 µm, insbesondere im Bereich von 10 µm - 20 µm. Besonders bevorzugt entspricht die Schichtdicke der Schicht aus Material B der Schichtdicke von Material A.

Die jeweils zwei entlang der Hauptachse der Leiterstruktur verlaufenden Bereiche aus Material A sind so angeordnet, dass die Fläche jeder Orthogonalprojektion des gesamten Verbinders mindestens 10% größer ist als die Fläche der Orthogonalprojektion von jedem der Bereiche von Material A, unabhängig von der gewählten Projektionsrichtung. Besonders bevorzugt ist die Fläche jeder Orthogonalprojektion des gesamten Verbinders mindestens 30% und ganz besonders bevorzugt mindestens 50 % größer als die Fläche der Orthogonalprojektion von jedem der Bereiche von Material A.

Insbesondere betreffen die in dieser Anmeldung genannten Projektionsszenarien auf Projektionen zu, bei denen ein Bereich von Material A den kürzest möglichen Abstand zur Projektionsfläche aufweist. Diese konkrete Projektion entspricht der Anwendung des Verbinders im Kontext einer Solarzelle, bei der ein Bereich von Lotmaterial A der Oberfläche der Solarzelle zugewandt ist, um diese zu kontaktieren. In einer bevorzugten Ausführung ist der Verbinder so ausgestaltet, dass die Orthogonalprojektion von jedem der Bereiche von Material A jeweils gleich weit von den Rändern der Orthogonalprojektion des gesamten Verbinders entfernt ist. Bevorzug sind die Bereiche von Material A so angeordnet, dass die Orthogonalprojektion jedes Bereichs von Material A symmetrisch zu der Orthogonalprojektion des gesamten Verbinders orientiert ist.

Die Breite der beiden entlang ihres Umfangs abwechselnden Bereiche aus Material A kann gleich oder verschieden sein. Die Breite der zwei entlang ihres Umfangs abwechselnden Bereiche aus Material B kann gleich oder verschieden sein.

Der Anteil des Materials B bedeckt auf der gesamten Oberfläche der Leiterstruktur vorzugsweise 5 - 95%, insbesondere 30 - 80% und ganz besonders bevorzugt 40 - 60% der Fläche. In einer besonders bevorzugten Ausführungsform ist die Leiterstruktur in dem Bereichen, in dem der Verbinder nicht mit den zu verbindenden Solarzellenelektroden in Kontakt steht, also zwischen zwei Solarzellen in einem Photovoltaikmodul, vollständig mit einer Schicht aus Material B umgeben. Dadurch kann Lotmaterial eingespart werden.

Der Verbinder umfasst zwei entlang des Umfangs abwechselnd Bereiche von Material A die durch Bereiche von Material B voneinander getrennt sind. Dabei ist es vorteilhaft, wenn die entlang ihres Umfangs abwechselnden Bereiche von Material A so angeordnet sind, dass sich die beiden Bereiche von Material A symmetrisch auf gegenüberliegenden Seiten der Leiterstruktur befinden. Dadurch können Frontseitenelektroden mit Rückseitenelektroden verbunden werden.

Weiterhin betrifft die Erfindung ein Verfahren zur Herstellung eines Verbinders, geeignet zum Verbinden einer ersten Solarzellenelektrode mit einem weiteren Element, umfassend die Schritte:
a) Bereitstellen einer metallischen Leiterstruktur,
b) teilweises Beschichten der metallischen Leiterstruktur entlang der Hauptachse mit zwei voneinander getrennten Bereichen, mit einem dielektrische Material B, und
c) teilweises Beschichten der metallischen Leiterstruktur entlang der Hauptachse mit zwei voneinander getrennten Bereichen entlang des Umfangs, mit einem Lotmaterial A,
wobei das teilweise Beschichten der Materialien A und B jeweils so erfolgt, dass die Leiterstruktur entlang des Umfangs abwechselnd mit diesen Materialien beschichtet wird.

In dem erfindungsgemäßen Verfahren erfolgt Schritt a) notwendiger Weise vor den Schritten b) und c). Die Reihenfolge der Schritte b) und c) ist nicht weiter festgelegt, was auch durch den Begriff "umfassend" zum Ausdruck kommt. In einer bevorzugten Ausführungsform erfolgt Schritt b) vor Schritt c).

Das erfindungsgemäße Verfahren schließt nicht aus, dass vor, zwischen oder nach den Schritten a) - c) weitere Schritte durchgeführt werden.

In einer bevorzugten Ausführungsform wird die bereitgestellte Leiterstruktur in Schritt a) gereinigt und dadurch von Rückständen, z.B. Fetten und Oxiden, befreit.

In Schritt a) wird eine metallische Leiterstruktur bereitgestellt, wie sie in dieser Anmeldung beschrieben ist. Bevorzugt wird die Leiterstruktur als fortlaufendes Band oder als fortlaufender Draht auf einer Rolle bereitgestellt. Die aufgerollte Leiterstruktur kann bevorzugt einige hundert bis einige tausend Meter lang sein. Wenn die Leiterstruktur in Form einer Rolle bereitgestellt wird, wird die Leiterstruktur in Schritt a) bevorzugt von der Rolle abgerollt. In einer besonders bevorzugten Ausführungsform erfolgt in Schritt a) zusätzlich eine Vorbehandlung. Die Vorbehandlung kann beispielsweise ausgewählt sein aus Weichglühen und Plasmaätzen in inerter Atmosphäre. Eine inerte Atmosphäre kann zum Beispiel eine Stickstoff- oder Argonatmosphäre sein. Wenn die Leiterstruktur mittels Weichglühen und Plasmaätzen behandelt wird, erfolgt bevorzugt das gesamte Herstellungsverfahren des Verbinders in einer Inertgasatmosphäre.

In Schritt b) wird die metallische Leiterstruktur entlang der Hauptachse mit zwei voneinander getrennten Bereichen, mit einem dielektrischen Material B, beschichtet.

Bevorzugt besteht das Beschichten in Schritt b) aus zwei Unterschritten. Im ersten Unterschritt wird Material B oder ein Vorläufer von Material B auf die Leiterstruktur aufgebracht und im zweiten Unterschritt wird Material B oder ein Vorläufer von Material B auf der Leiterstruktur fixiert. Wenn das Material B eine Keramik ist, wird bevorzugt ein Vorläufer von Material B in Form einer keramikhaltigen Paste enthaltend Keramikpartikel aufgetragen. Wenn Material B ein Polymermaterial ist, wird bevorzugt ein vernetzbares Harz (insbesondere ein Kunstharz) oder ein Lack auf die Leiterstruktur aufgetragen. Ein vernetzbares Harz und ein Lack können Vorläufer von Material B sein, die in einem weiteren Unterschritt fixiert werden können. Der Lack kann ein Lotstopplack sein, der die Benetzung der Oberfläche der Leiterstruktur mit flüssiger Lotlegierung in den aufgetragenen Bereichen verhindert.

Bevorzugt erfolgt das Auftragen des dielektrischen Materials B durch Drucken oder mittels gängiger Extrusionsverfahren. Das Drucken kann als Kontaktdruckverfahren oder als kontaktloses Druckverfahren ausgeführt sein. Das Kontaktdruckverfahren kann ausgewählt sein aus der Gruppe bestehend aus Hochdruck, Flachdruck (z.B. Offsetdruck) und Tiefdruck. In einer Ausführungsform kann jedes der vorgenannten Druckverfahren als Rotationsdruckverfahren durchgeführt werden. Bevorzugt wird das Material B kontinuierlich, z.B. in einem Rolle-zu-Rolle Verfahren, auf die Leiterstruktur aufgebracht. Dazu ist es vorteilhaft, wenn die Leiterstruktur (z.B. ein Metallband) dem Druckprozess kontinuierlich einem Druckkopf zugeführt wird. Der Druckkopf hat entsprechende Aussparungen in denen eine Beschichtung der Leiterstruktur mit Material B erfolgen kann. Die Bereiche der Leiterstruktur außerhalb der Aussparungen werden mittels Blenden oder Einbringen von Gas- oder Lösemittelströmen frei von der Beschichtung mit Material B gehalten.

In einer anderen bevorzugten Ausführungsform kann das Material B oder der Vorläufer für Material B durch ein kontaktloses Druckverfahren auf die Leiterstruktur aufgetragen werden. Das kontaktlose Druckverfahren, kann z.B. ausgewählt sein aus Sprühen, Inkjet-Printing oder Tropfen (*Dispensing*).

In einer bevorzugten Ausführungsform weist die Leiterstruktur beim Beschichten mit Material B eine Temperatur im Bereich von 40 - 70°C auf, bevorzugt ca. 60±5°C. Bevorzugt erfolgt das Drucken mit einer Auftragungsgeschwindigkeit auf der Leiterstruktur von mindestens 100 m/min, oder bevorzugt bis 300 m/min, wobei sich die Meterangabe auf die Länge der bedruckten Leiterstruktur bezieht.

In einer anderen bevorzugten Ausführungsform kann Material B als Folie auf die Leiterstruktur aufgetragen werden, die auf die Leiterstruktur laminiert wird. Die Folie kann beispielsweise eine Polymerfolie sein.

In einem zweiten Unterschritt erfolgt optional eine Fixierung der Schicht des Materials B, beziehungsweise des Vorläufers für Material B. Durch die Fixierung kann das im ersten Unterschritt aufgetragene Material B chemisch verändert werden, zum Beispiel durch die Vernetzungsreaktion eines Polymernetzwerks. Wenn eine Keramikpaste auf die Leiterstruktur aufgebracht wurde, kann die Fixierung bevorzugt durch Einbrennen erfolgen. Bevorzugt führt das Fixieren einer Keramikpaste nicht zu einer Änderung der Zusammensetzung der Keramik.

Die Fixierung eines im ersten Unterschritt aufgetragenen Polymermaterials in Form eines Harzes oder Lacks kann bevorzugt erfolgen durch UV-Strahlung (z.B. mittels Breitband-UV Strahler) oder Wärmezufuhr. Bevorzugt erfolgt während der Fixierung des Harzes oder Lacks eine Vernetzungsreaktion.

Für den Fall, dass eine Folie auf die Leiterstruktur aufgetragen wird, wird diese bevorzugt fixiert. Insbesondere wird die Folie zumindest teilweise auf die Schmelztemperatur erhitzt. Bevorzugt wird durch das Erhitzen die Haftung der Folie zur Leiterstruktur erhöht. In einer alternativen bevorzugten Ausführungsform wird die Folie nicht in einem weiteren Unterschritt behandelt.

Durch die Fixierung der im ersten Unterschritt aufgebrachten Beschichtung aus Material B oder einem Vorläufer aus Material B auf der Leiterstruktur, kann im zweiten Unterschritt unter anderem die Haftung der Schicht zur Leiterstruktur erhöht werden und die Schicht aus Material B kann selbst Widerstandsfähiger gegen mechanische und chemische Einflüsse gemacht werden.

In einer weiteren bevorzugten Ausführungsform von Schritt b) wird zuerst die Leiterstruktur vollständig mit Material B beschichtet, und anschließend wird die

Beschichtung mit Material B teilweise wieder entfernt, sodass zwei voneinander getrennte Bereich von Material B entlang der Hauptachse auf der Leiterstruktur verbleiben. Das teilweise Entfernen kann beispielsweise mittels Laserablation erfolgen. In einer besonders bevorzugten Ausführung wird die Leiterstruktur zuerst vollständig mit einem Vorläufer von Material B, insbesondere einem Lotstopplack, beschichtet und dieser fixiert, insbesondere vernetzt, und anschließend wird das fixierte Material B teilweise mit Laserablation entfernt. Durch diese Laserablation wird die Oberfläche der Leiterstruktur teilweise wieder freigelegt.

In einer bevorzugten Ausführungsform weist das Material B nach der Fixierung ein Elastizitätsmodul von 7 GPa oder weniger, insbesondere 5 GPa oder weniger und besonders bevorzugt 2 GPa oder weniger auf. Der Anteil der Beschichtung mit Material B an der gesamten Oberfläche der Leiterstruktur beträgt zwischen 5% und 95%, bevorzugt zwischen 30% und 80%.

In einer besonders bevorzugten Ausführungsform erfolgt vor Schritt c) eine Vorbehandlung. Die Vorbehandlung kann beispielsweise das Aufbringen eines Flussmittels auf die nicht mit Material B beschichteten Bereiche der Leiterstruktur enthalten. Das Auftragen kann insbesondere dann notwendig sein, wenn das Herstellungsverfahren des Verbinders nicht vollständig unter einer Inertgasatmosphäre durchgeführt wird. Eine Inertgasatmosphäre enthält bevorzugt nicht mehr als 1 Vol.% Sauerstoff.

In Schritt c) erfolgt ein teilweises Beschichten der metallischen Leiterstruktur entlang der Hauptachse mit zwei voneinander getrennten Bereichen, mit einem Lotmaterial A. Bevorzugt erfolgt die Beschichtung der Leiterstruktur mit Lotmaterial A in den Bereichen, die nicht mit Material B beschichtet sind. Wenn es sich um ein Kupferband handelt, wird zum Beispiel bevorzugt nur die freie Kupferoberfläche mit Lotmaterial bedeckt. Die Beschichtung aus Material B, die bevorzugt ein Polymermaterial und insbesondere ein gehärteter Lotstopplack ist, wird von flüssiger, geschmolzener Lotlegierung bevorzugt nicht benetzt.

Das Beschichten der Leiterstruktur mit Lotmaterial A kann auf unterschiedliche Weise erfolgen. In einer bevorzugten Ausführungsform kann die bereits mit Material B beschichtete Leiterstruktur durch eine Tauchbeschichtung mit Material A beschichtet werden. Bei der Tauchbeschichtung kann die bereits mit Material B beschichtete Leiterstruktur in ein Schmelzbad aus flüssiger Lotlegierung oder ein Bad einer Lotpaste getaucht werden. Eine Tauchbeschichtung hat den Vorteil, dass besonders einfach entlang des Umfangs abwechselnd umlaufende Bereiche aus Material A auf der mit Material B vorbeschichteten Leiterstruktur hergestellt werden können. Durch die Tauchbeschichtung können die nicht mit Material B beschichteten Bereiche der Leiterstruktur entlang der Hauptrichtung mit Material A beschichtet werden. Bevorzugt wird die Leiterstruktur in ein Bad aus flüssiger Lotlegierung eingetaucht. Bevorzugt wird die Leiterstruktur, insbesondere ein Kupferband, kontinuierlich durch ein Schmelzbad einer Lotlegierung geführt. Die Lotlegierung des Schmelzbads weist bevorzugt einen Schmelzpunkt auf, der mindestens 100°C, insbesondere mindestens 200°C, unter der Schmelztemperatur der Leiterstruktur liegt. Die Lotlegierung kann ausgewählt sein aus Lotlegierungen wie sie hierin beschrieben sind.

Anschließend kann überschüssige, flüssige Lotlegierung, z.B. mit Druckluft oder durch Abstreifen, entfernt werden. Bevorzugt weist die Schicht von flüssiger Lotlegierung auf der Leiterstruktur die gleiche oder zumindest eine ähnliche Schichtdicke auf wie die Schicht aus Material B. In einer alternativen Ausführung weist die Schicht von Material A eine höhere Dicke auf als die Schicht von Material B. Die Schicht von Material B kann eine einheitliche oder eine variierende Schichtdicke aufweisen.

Nach dem Durchlaufen des Schmelzbads kann die flüssige Lotlegierung abkühlen und erstarren, wodurch entlang des Umfangs abwechselnde Bereiche des Lotmaterials A und des dielektrischen Materials B auf der Leiterstruktur gebildet werden können.

In einer alternativen Ausführung der Erfindung kann die bereits mit Material B beschichtete Leiterstruktur durch Bedrucken der Leiterstruktur mit einer Lotpaste beschichtet werden. Bevorzugt enthält die Lotpaste mindestens Partikel einer Lotlegierung und ein Flussmittel. Weiterhin kann die Lotpaste Lösungsmittel und Additive umfassen. Die Lösungsmittel können organische oder wässrige Lösungsmittel sein. Die Additive können bevorzugt Rheologiemodifizierer, wie z.B. Thixotropiemittel, Verdicker oder Harze, sein. Das Lösungsmittel kann ein organisches Lösungsmittel oder ein wässriges Lösungsmittel sein.

In einem ersten Schritt wird die Lotpaste auf die Bereiche der Leiterstruktur aufgedruckt, die nicht mit Material B beschichtet sind. In einem weiteren Schritt nach dem Beschichten kann die Lotpaste auf der Leiterstruktur fixiert werden. Das Fixieren der Lotpaste geschieht bevorzugt durch Erwärmen oder Erhitzen. Erwärmen bedeutet in diesem Zusammenhang, dass die Lotpaste unter den Schmelzpunkt der enthaltenen Lotlegierung erwärmt wird, so dass die Schicht der Paste trocknet und flüchtige Bestandteile entweichen. Erhitzen meint in diesem Zusammenhang, dass die Schicht der Lotpaste über den Schmelzpunkt der enthaltenen Lotlegierung erhitzt wird. Bevorzugt wird beim Erhitzen eine zusammenhängende Schicht einer Lotlegierung gebildet, während die flüchtigen Bestandteile der Paste weitestgehend entfernt werden, z.B. durch Verdampfen oder Verbrennen. Auf diese Weise kann ein erfindungsgemäßer Verbinder erzeugt werden.

Wie oben bereits ausgeführt, ist die Reihenfolge der Schritte b) und c) nicht weiter festgelegt. In einer vorteilhaften Ausbildung der Erfindung kann der Verbinder hergestellt werden, indem zuerst eine Schicht aus Lotmaterial A entlang der Hauptachse auf die Leiterstruktur aufgebracht wird und anschließend eine Schicht aus dielektrischem Material B. Diese Verfahrensreihenfolge kann beispielsweise dadurch realisiert werden, dass zuerst ein Lotmaterial A in Form einer Lotpaste in voneinander getrennten Bereichen entlang der Hauptachse auf die Leiterstruktur aufgebracht wird und anschließend zwei getrennte Bereiche einer Schicht des Materials B auf die nicht mit Material A beschichteten Bereiche. Bevorzugt erfolgt in dieser Ausführungsform, bei der Schritt b) nach Schritt c) erfolgt, sowohl das Aufbringen von Material A als auch von Material B jeweils durch einen Druckprozess.

Auf dem erfindungsgemäß hergestellten Verbinder wechseln die mit Material B versehenen Bereiche mit den mit Material A beschichteten Bereichen entlang des Umfangs ab. Die jeweils zwei voneinander getrennten Bereiche von Material A und Material B beschichten die Leiterstruktur jeweils durchgängig entlang der Hauptachse.

Wenn die Leiterstruktur in Schritt a) als fortlaufendes Band oder Draht bereitgestellt wurde, wird die Leiterstruktur nach Ablauf der Schritte b) und c) bevorzugt in einzelne Stücke geschnitten und so der fertige Verbinder erhalten. Die Länge der zerschnittenen Leiterstruktur liegt bevorzugt im Bereich von 100 - 600 mm und ganz besonders bevorzugt im Bereich von 200 - 400 m.

Die in den Schritten b) und c) beschichtete Leiterstruktur kann optional, nachdem der Beschichtungsvorgang beendet ist, wieder auf eine Rolle (auch Spule genannt) aufgerollt werden. Besonders bevorzugt wird die Leiterstruktur nach Ablauf der Schritte b) und c) wieder aufgerollt und erst während des Verfahrens zur Herstellung eines Photovoltaikbauteils abgerollt und auf die jeweils für die Anwendung benötigte Länge zugeschnitten.

In einer Ausführungsform betrifft die Erfindung ein Photovoltaikbauteil, umfassend eine erste Solarzellenelektrode und ein weiteres Element, wobei die Solarzellenelektrode und das weitere Element durch einen erfindungsgemäßen Verbinder miteinander verbundenen sind. Bevorzugt ist die erste Solarzellenelektrode des Photovoltaikbauteils eine Frontseiten- oder eine Rückseitenelektrode. Eine Solarzelle enthält bevorzugt mindestens ein Halbleiterschicht, die von mindestens zwei Solarzellenelektroden entgegengesetzter Polarität kontaktiert wird. Die Halbeiterschicht ist bevorzugt ein dotierter Siliziumwafer. Bevorzugt ist die Halbleiterschicht ein monokristalliner oder multikristalliner Siliziumwafer. Typischer Weise sind die mindestens zwei Solarzellenelektroden einer Solarzellen mindestens eine Rückseitenelektrode und mindestens eine Frontseitenelektrode, das heißt, die Elektroden sind auf entgegengesetzten Seiten der Halbleiterschicht angeordnet. Die Frontseitenelektrode befindet sich auf der lichteinfallenden Seite, während sich die Rückseitenelektrode auf der vom Licht abgewandten Seite befindet. In einer anderen Ausführungsform können die mindestens zwei Elektroden auf der gleichen Seite des Halbleitersubstrats angeordnet sein (auch *Back Contact Solar Cell* genannt).

Die Rückseitenelektrode kann zum Beispiel eine flächig aufgetragene Metallschicht sein. Vorzugsweise enthält diese Metallschicht Aluminium mit silberhaltigen Kontaktierungsstellen.

Die Frontseitenelektrode des Photovoltaikbauteils ist bevorzugt ein Busbar. Der Busbar kann mehrere oder alle Fingerelektroden miteinander verbinden und dient dazu, den von den Fingerelektroden gesammelten Strom effizient abzuleiten. Gleichzeitig kann der Busbar dazu dienen mechanisch robuste Kontaktflächen, z.B. zum Löten, zur Verfügung zu stellen. Der Busbar hat bevorzugt einen größeren Leitungsquerschnitt als eine Fingerelektrode. Der Durchmesser eines Busbars kann bevorzugt im Bereich von 100 µm - 2 mm liegen und die Höhe beträgt bevorzugt 1 - 20 µm. Für den Busbar sind dem Fachmann unterschiedliche Designs bekannt. Ein Busbar kann als durchgehende gleichförmige Leiterbahn, eingeschnürte Leiterbahn (z.B. in Form einer Perlenkette) sowie mit Unterbrechungen ausgeführt sein. In einer bevorzugten Ausführungsform kontaktiert ein Busbar mehrere, insbesondere alle vorhandenen Fingerelektroden. Der Verbinder ist bevorzugt breiter als der Busbar, um ein korrektes Ausrichten des Verbinders zum Busbar zu erleichtern. Um eine möglichst geringe Abschattung der Halbleiterschicht zu erreichen, unterscheidet sich die Breite von Verbinder und Busbar bevorzugt um 50% oder weniger, insbesondere 20% oder weniger und ganz besonders bevorzugt um 10% oder weniger.

Sowohl die Rückseitenelektrode als auch die Frontseitenelektrode werden bevorzugt hergestellt, indem eine Leiterpaste auf der Halbleiterschicht aufgetragen wird und die aufgetragene Leiterpaste anschließend eingebrannt wird. Die Leiterpaste kann durch Drucken, wie z.B. Siebdrucken oder Schablonendrucken, auf der Halbleiterschicht aufgetragen werden. Eine Leiterpaste umfasst typischer Weise elektrisch leitfähige Metallpartikel, eine Glasfritte und ein organisches Medium. Wenn die Leiterpaste zur Herstellung einer Rückseitenelektrode eingesetzt wird, enthalten die elektrisch leitfähigen Metallpartikel bevorzugt Silber und/ oder Aluminium. Wenn die Leiterpaste zur Herstellung einer Frontseitenpaste eingesetzt wird, enthalten oder bestehen die elektrisch leitfähigen Metallpartikel bevorzugt aus Silber. Nach dem Auftragen kann das Halbleitersubstrat zusammen mit der bzw. den aufgetragenen Leiterpasten gebrannt werden, wodurch die eine Solarzellelektrode erhalten wird. Durch das Brennen kann das organische Medium entfernt werden und eine mechanisch feste und elektrisch leitfähige Elektrode erhalten werden. Die erhalten Solarzellelektroden umfassen somit bevorzugt eine Mischung aus Glas und Metall.

In dem erfindungsgemäßen Photovoltaikbauteil wird eine erste Solarzellenelektrode über den erfindungsgemäßen Verbinder mit einem weiteren Element verbunden. Bevorzugt ist das weitere Element eine weitere Solarzellenelektrode einer Solarzelle. Besonders bevorzugt ist das weitere Element eine weitere Solarzellenelektrode mit entgegengesetzter Polarität zur ersten Solarzellenelektrode. Zum Beispiel können die erste Solarzelle und die weitere Solarzelle gleich sein. Der Verbinder verbindet bevorzugt die Frontseitenelektrode der ersten Solarzellen mit der Rückseitenelektrode der weiteren Solarzelle. Alternativ kann der Verbinder auch die Rückseitenelektrode einer ersten Solarzelle mit der Frontseitenelektrode einer weiteren Solarzelle verbinden. Das erfindungsgemäße Photovoltaikbauteil kann auch Teil einer Kette von Solarzellen sein, die durch den Verbinder verbunden sind, d.h. neben der ersten und der weiteren Solarzellenelektrode können weitere Solarzellenelektroden jeweils mit weiteren Verbindern verbunden sein.

In einer bevorzugten Ausführung wird der Kontakt zwischen der ersten Solarzellenelektrode und dem Verbinder durch eine Lotverbindung hergestellt. Bevorzugt wird die Lotverbindung unter Aufschmelzen mindestens eines Bereiches von Material A auf dem Verbinder hergestellt. Dabei trägt ein entlang des Umfangs abwechselnder Bereich auf dem Verbinder, der mit einem Lotmaterial A beschichtet ist, zum mechanischen und elektrischen Kontakt zu der ersten Solarzellenelektrode bei. Besonders vorteilhaft wird der elektrische Kontakt zwischen Verbinder und der Solarzellenelektrode durch einen ersten Bereiche aus Material A hergestellt und der elektrische Kontakt zwischen Verbinder und dem weiteren Element durch den zweiten Bereich von Material A hergestellt, wobei die Bereiche von Material A jeweils durch eine Schicht aus Material B voneinander getrennt sind. Alternativ kann der Kontakt zwischen Verbinder und erster Solarzellenelektrode und zwischen Verbinder und dem weiteren Element durch denselben Bereich von Lotmaterial A bereitgestellt werden.

Dadurch, dass der erfindungsgemäße Verbinder im Kontaktbereich mit der ersten Solarzellenelektrode und im Kontaktbereich mit dem weiteren Element zum Teil mit Material B beschichtet ist, kann beim Verlöten der Solarzellenelektrode mit dem Verbinder verhindert werden, dass die Fingerelektroden mit Material A in Kontakt kommen. Insbesondere wird die Lötfläche, die durch das geschmolzene Lotmaterial gebildet wird durch die Bereiche aus Material B begrenzt, sodass flüssiges Lotmaterial bevorzugt nicht mit den Fingerelektroden in Kontaktkommen kann.

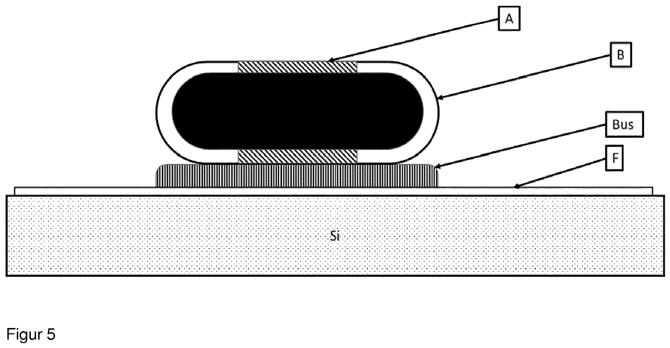

In Figur 5 ist ein Querschnitt eines erfindungsgemäßen Verbinders dargestellt, der mit einem Busbar (Bus) über das Lotmaterial A in Kontakt steht. Der Verbinder kontaktiert hier ausschließlich den Busbar (Bus) und kommt nicht mit der Fingerelektrode (F) in Kontakt, da das Material A von Material B begrenzt wird. Si kennzeichnet in Figur 5 einen Siliziumwafer. Die Fläche, an der Verbinder und Busbar in Kontakt stehen, wird als Kontaktfläche bezeichnet.

Im erfindungsgemäßen Photovoltaikbauteil haben die entlang des Umfangs abwechselnden Bereiche aus Material B dielektrische Eigenschaften und tragen bevorzugt nicht zum elektrischen Kontakt zwischen Solarzellenelektrode und Verbinder bei. In einer bevorzugten Ausführung tragen die entlang des Umfangs abwechselnden Bereiche aus Material B zur mechanischen Kontaktierung bei, z.B. durch Haftung, indem Material B als Klebstoff wirkt.

Das erfindungsgemäße Photovoltaikbauteils wird bevorzugt hergestellt, durch ein Verfahren umfassend die folgenden Schritte:
- Bereitstellen einer Solarzelle mit mindestens einer Solarzellenelektrode, insbesondere eines Busbars, und Bereitstellen eines weiteren Elements
- Bereitstellen eines erfindungsgemäßen Verbinders,
- Positionieren des Verbinders relativ zu der mindestens einen Solarzellenelektrode und dem weiteren Element,
- Verbinden der mindestens einen Solarzellenelektrode und des weiteren Elements mit Hilfe des Verbinders

Im folgenden Abschnitt ist die Herstellung eines erfindungsgemäßen Photovoltaikbauteils beschrieben, bei dem eine Solarzellenelektrode durch einen Verbinder mit einem weiteren Element verbunden ist. Die Erfindung umfasst jedoch auch Ausführungsformen, bei denen eine Solarzelle mehrere Solarzellenelektroden, insbesondere Busbars, aufweist, die jeweils über einen Verbinder mit dem weiteren Element, bzw. den weiteren Elementen, verbunden werden.

Um das Photovoltaikbauteil herzustellen, wird eine Solarzelle bereitgestellt, die mindestens eine Solarzellenelektrode aufweist. Bevorzugt umfasst die Solarzelle mindestens eine Frontseitenelektrode, z.B. in Form eines Busbars, und eine Rückseitenelektrode. Das weitere Element ist bevorzugt eine weitere Solarzellenelektrode einer Solarzelle. Insbesondere ist die weitere Solarzelle gleich mit der ersten bereitgestellten Solarzelle. Alternativ kann das weitere Element des Photovoltaikmoduls auch eine Anschlussleitung für ein Photovoltaikmodul sein. Die Anschlussleitung kann dazu dienen den Strom von mehreren in Reihe geschalteten Solarzellen abzuleiten.

Weiterhin wird mindestens ein erfindungsgemäßer Verbinder bereitgestellt. Bevorzugt wird der Verbinder bereitgestellt, indem er von einer Rolle abgerollt wird. Bevorzugt wird diese abgerollte und bereits beschichtete Leiterstruktur auf die erforderliche Länge zugeschnitten und dadurch ein für die jeweilige Anwendung passender Verbinder erhalten. Insbesondere wird der Verbinder derart bereitgestellt, dass die Länge ausreicht, um den Busbar einer Solarzelle mit der Solarzellenelektrode einer weiteren Solarzelle, insbesondere einer Rückseitenelektrode, zu verbinden. Das bedeutet, dass der Verbinder in dieser Ausführung etwa doppelt so lang ist wie die Länge einer Solarzelle. In einer bevorzugten Ausführungsform entspricht die Zahl der bereitgestellten Verbinder der Zahl der Busbars, die auf der Solarzelle vorhanden sind. Insbesondere wird pro vorhandenem Busbar eine Rolle mit beschichteter Leiterstruktur bereitgestellt, die zu dem erfindungsgemäßen Verbinder zugeschnitten werden kann.

Um eine möglichst geringe Abschattung der Halbleiterschicht zu erreichen, unterscheidet sich die Breite von bereitgestelltem Verbinder und der ersten Solarzellenelektroden, z.B. einem Busbar, bevorzugt um 50% oder weniger, insbesondere 20% oder weniger und ganz besonders bevorzugt um 10% oder weniger. Der Verbinder kann sowohl breiter als auch schmaler sein als die erste Solarzellenelektrode. Bevorzugt ist der erfindungsgemäße Verbinder breiter als der Busbar.

Weiterhin wird der bereitgestellte Verbinder relativ zu der Solarzellenelektrode und dem weiteren Element positioniert. Dazu wird bevorzugt der bereitgestellte Verbinder mit der ersten Solarzellenelektroden, insbesondere dem Busbar, in Deckung gebracht, z.B. über dem Busbar zentriert. Da der Verbinder bevorzugt länger ist als der Busbar, steht ein Teil, z.B. die Hälfte der Länge, des Verbinders über die erste Solarzelle über.

Anschließend kann das weitere Element so positioniert werden, das es mit dem Verbinder kontaktiert werde kann. Wenn eine Frontseitenelektrode einer ersten Solarzelle mit einer Rückseitenelektrode einer weiteren Solarzelle verbunden werde soll, kann der Verbinder zuerst auf der Frontseite entsprechend positioniert werden und anschließend kann die weitere Solarzelle mit ihrer Rückseite auf dem überstehenden Teil des Verbinder positioniert werden.

Der auf der Solarzellenelektrode und dem weiteren Element positionierte Verbinder wird anschließend mit diesen verbunden. Das Verbinden erfolgt bevorzugt, indem der positionierte Verbinder angepresst und verlötet wird. Zum Verlöten wird bevorzugt die Anordnung aus Solarzellenelektrode, Verbinder und weiterem Element so erhitzt, dass die entlang des Umfangs abwechselnden Bereiche des Lotmaterials A auf dem Verbinder schmelzen und eine Lötverbindung mit der Solarzellenelektrode hergestellt wird. Das Erhitzen des Lotmaterials erfolgt vorzugsweise mit Hilfe von Infrarotstrahlung.

Dadurch, dass die Fläche jeder Orthogonalprojektion des gesamten Verbinders mindestens 10% größer ist als die Fläche der Orthogonalprojektion von jedem der Bereiche von Material A und durch die Anwesenheit der Bereiche von Material B kann das geschmolzene Lotmaterial nicht den gesamten Kontaktbereich benetzen, wodurch das Risiko einer Beschädigung der Fingerelektroden vermieden werden kann.

Es kann bevorzugt sein, die Solarzellenelektrode und das weitere Element vor dem eigentlichen Löten vorzuheizen, um die mechanischen Spannungen zu minimieren. Weiterhin werden der Zellverbinder und die Solarzellenelektrode vorzugsweise während des Lötprozesses zusammengepresst. Nach dem Löten wird in den Bereichen des Verbinders, die entlang ihres Umfangs abwechselnd mit Lotmaterial A beschichtet sind eine mechanisch feste und elektrisch leitfähige Verbindung erhalten. Ein Photovoltaikbauteil, bei dem die erste Solarzellenelektrode über einen Verbinder mit einer weiteren Solarzellenelektrode einer weiteren Solarzelle verbunden ist, wird auch Photovoltaikmodul genannt. Der erfindungsgemäße Verbinder kann bevorzugt auch dazu verwendet werden, mehr als zwei Solarzellen zu Photovoltaikmodulen zu verbinden.

Der erfindungsgemäße Verbinder lässt sich in einem industrieüblichen Prozess analog zu vollständig mit Lot beschichteten Kupferbändern verarbeiten und ermöglichen somit die elektrische Reihenschaltung und mechanische Verbindung von Solarzellen für die Fertigung von Solarmodulen.

Im Folgenden soll die allgemeine Lehre der Erfindung anhand von konkreten Ausführungsbeispielen erläutert werden.

### Beispiele

### 1) Herstellung des beschichteten Verbinders:

Zuerst wurde eine metallische Leiterstruktur in Form eines auf eine Spule aufgerollten Kupferbandes bereitgestellt (Kupfer: ETP-Standard, Rp0,2 = 80 MPa, Maße: 1,5 mm breit, 200 µm dick). Das Kupferband wurde von der Spule abgerollt und eine thermische Behandlung (Annealing, Weichglühen) und Reduktion der Oberfläche mittels Plasmabehandlung durchgeführt. Die weiteren Schritte bis zum Lotbad fanden unter inerter Atmosphäre statt (Sauerstoffanteil < 50ppm).

Anschließend wurde UV härtender Lotstopplack (ELPEPCB^{®} SD 2460/201 UV-FLEX) mittels Extrusionsverfahren auf das Kupferband an den Seitenbereichen und in einem Teilbereich der späteren Kontaktflächen aufgebracht. Das Band wurde dabei durch eine Kammer gezogen.

Im Innern der Kammer befand sich der Lack unter einem Druck. Eingang und Ausgang waren durch einen schmalen Spalt so abgedichtet, so dass kein Lack aus der Kammer austrat. Die Beschichtung der Kantenbereiche erfolgte kontinuierlich durch Anhaftung des Lacks beim Transport durch den Lack in der Kammer. In den Mittenbereichen wurde die Benetzung mit Lack mittels Blenden verhindert.

Die Dicke der Lackbeschichtung betrug 15 µm. Der Lotstopplack beschichtete die Front - und Rückseite des Kupferbandes jeweils so, dass auf den Kontaktflächen 1 mm breite, von Lotstopplack freie Bereiche auf Front- und Rückseite entstand. Der aufgebrachte Lotstopplack wurde darauffolgend mittels UV-Licht einer Quecksilber-Hochdruckdampflampe bei einer Oberflächentemperatur des Substrats von ca. 60°C gehärtet. Die Schichtdicke der Lackschicht nach dem Härten betrug ebenfalls ca. 15 µm. Im nächsten Schritt wurde das teilweise mit Lotstopplack beschichtete Kupferband in ein Lotbad getaucht, das geschmolzene Lotlegierung (Sn60Pb40) enthielt. Die Schichtdicke des Lotes wurde dabei durch die Temperatur des Lotbads, die Vorschubgeschwindigkeit des Kupferbands sowie durch ein "Abstreifen" mittels Luftmessern direkt nach dem Austritt aus dem Lotbad bestimmt. Nach dem Herausziehen war das Kupferband im vom Lotstopplack nicht benetzen Bereichen mit der Lotlegierung benetzt. Die Bereiche des Lotstopplacks waren nicht mit Lotlegierung benetzt. Nach dem Erstarren wies die Schicht der Lotlegierung eine Schichtdicke von etwa 15 µm auf. Nach dem Erstarren wurde das beschichtete Kupferband wieder auf eine Spule aufgerollt.

### 2) Bereitstellung von Solarzellen

Als Solarzelle wurde eine p-Typ Zelle mit n-Emitter der Fa. Q-Cells eingesetzt (Widerstand: 90 Ohm/square). Die Oberfläche wies eine Si3Nx Antireflektiv-Beschichtung auf der Frontseite auf. Mit der kommerziell erhältlichen Paste Heraeus SOL 9631C (Heraeus Deutschland GmbH) wurden Finger und drei Busbars auf der Frontseite mittels Siebdruck aufgetragen. Die Linienbreite der Finger betrug 40 µm, und die Breite der Busbars betrug 1,5 mm. Siebgedruckte Silber-Lötpads wurden auf der Rückseite mit der kommerziellen Paste Heraeus SOL205B (Heraeus Deutschland GmbH) aufgebracht. Die Aluminium - BSF auf der Rückseite wurde mittels siebgedruckter kommerzieller Aluminium-Paste ((RUX28K30, Guangzhou Ruxing Technology Development Co., Ltd. of Guangdong, China) aufgedruckt. Die Pasten wurden getrocknet und mit einer Maximaltemperatur von 900°C in einem Ofen eingebrannt.

### 3) Herstellung von Photovoltaikmodulen:

Mittels der Verbinder wurden, mit Hilfe des nachfolgend beschriebenen Verfahrens, Photovoltaikmodule aus zwei Solarzellen hergestellt:
Eine erste Solarzelle, wurde auf einer Montagefläche so positioniert, dass die Frontseitenelektroden mit den Busbars jeweils oben lagen.
Ein beschichtetes Kupferband wie es in Beispiel 1 hergestellt wurde, wurde auf Spulen aufgerollt bereitgestellt. Für jeden der drei Busbars pro Solarzelle wurde eine eigene Spule mit beschichtetem Kupferband bereitgestellt.

Die abwechselnd entlang des Umfangs mit Lot und Lotstopplack beschichteten Metallbänder wurden abgerollt, gereckt und über Führungen zu den Busbars der ersten Solarzelle geführt. Über den drei Busbars wurden die beschichteten Kupferbänder jeweils so positioniert und ausgerichtet, dass möglichst wenig Fläche der Solarzellen-Frontseite abgedunkelt wurde.

Die Verbinder wurden nach dem Abrollen und Positionieren über der ersten Solarzelle so zugeschnitten, dass die Länge der Verbinder für die Verbindung von zwei benachbarten Solarzellen ausreicht. Das bedeutet, dass die Länge eines zugeschnittenen Verbinders etwa doppelt so lang war wie die Länge der ersten Solarzelle. Eine Hälfte der jeweils abgerollten Kupferbänder kontaktierte einen Busbar auf der Frontseite der ersten Solarzelle, während die andere Hälfte der Verbinder über die Solarzelle hinaus ragte. Auf die Teile der drei Verbinder, die über die erste Solarzelle hinaus ragten, wurde die zweite Solarzelle gelegt. Dabei wurde die zweite Solarzelle so positioniert, dass die Verbinder die Rückseite der zweiten Solarzelle kontaktieren.

Nach dem Positionieren der zweiten Solarzelle wurden die Solarzellen und die drei Verbinder zusammengepresst. Anschließend wurde die Anordnung aus zwei Solarzellen und den Verbindern mittels IR-Strahlung so erhitzt, dass das Lotmaterial auf dem Verbinder eine Temperatur von etwa 200°C erreichte. Nach dem Erhitzen wurde die Anordnung abgekühlt, wobei die geschmolzene Lotlegierung erstarrte. Dadurch wurden zwei verbundene Solarzellen erhalten.

### 4) Vermessung und Vergleich unterschiedlicher Photovoltaikmodule

Zum Vergleich wurde ein weiteres Photovoltaikmodul aus zwei Solarzellen hergestellt, bei dem die Verbindung der zwei Solarzellenelektroden mit einem herkömmlichen, vollständig mit Lotlegierung (Sn60Pb40) beschichteten Kupferband erfolgte.

Zwei Sätze aus zwei miteinander verlöteten Solarzellen wurden seriellen miteinander verlötet. Anschließend wurden durch Einlaminieren sogenannte Minimodule von vier Zellen hergestellt. An diesen Minimodulen wurden der seriellen Widerstande (Rser), der Füllfaktor (FF) und die Elektrolumineszenz (EL) sowohl direkt nach der Herstellung als auch nach einer beschleunigten Alterung mit Warmauslagerung vermessen.

Für die beschleunigte Alterung wurden die zwei hergestellten Photovoltaikmodule zyklischen Temperaturwechseln zwischen -40 bis +55°C ausgesetzt. Die Modulleistung der Photovoltaikmodule wurde nach 100 und 500 Temperaturzyklen gemäß den in der Norm (IEC 61215) vorgegebenen Parametern getestet. Die Leistung STC der Module wurde bei 1000 W/m² und einen Zelltemperatur von 25°C nach IEC 60904 erfasst.

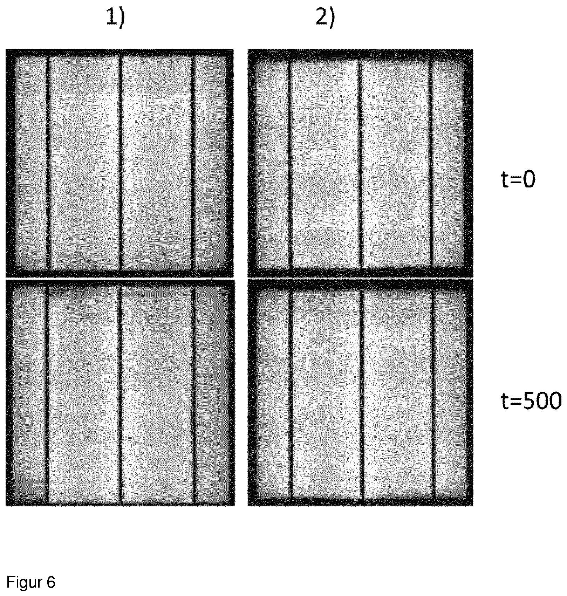

Tabelle 1 stellt die Ergebnisse der Messungen zusammen. Wie Tabelle 1 zu entnehmen ist, ist der Füllfaktor für das Vergleichsmodul mit Standardverbindern geringer bzw. nimmt nach Auslagerung weiter ab. Weiterhin ist im erfindungsgemäßen Beispiel der Abfall des Serienwiderstands (Rser) bzw. des Füllfaktors (FF) geringer. Figur 6, zeigt eine Elektrolumineszenzmessung. Dunkle Streifen auf der Solarzelle zeigen den Ausfall von Fingern an. Die Anzahl der Ausfälle von Fingern (dunkles grau) ist beim erfindungsgemäßen Beispiel vor und nach beschleunigten Alterung geringer.

**Tabelle 1**

| Probe Zellverbinder | Rser | FF | EL | Rser nach Alterung | FF nach Alterung | EL nach Alterung |
|---|---|---|---|---|---|---|
| | | t=0 | | t=500 | | |
| 1) Vergleich | - | - | - (Ausfall einzlner Finger an den Busbars) | -- | -- | - (Ausfall weiterer Fingerlinien an den Busbars) |
| 2) Erfindung | + | + | + (kein Ausfall der Finger) | + | + | + (praktisch keine Veränderung gegenüber der Ausgangsmessung) |

## Patentansprüche

1. Verbinder zum Verbinden einer ersten Solarzellenelektrode mit einem weiteren Element, wobei der Verbinder eine metallische Leiterstruktur aufweist und die Leiterstruktur entlang ihres Umfangs abwechselnd umlaufend mit jeweils zwei durchgängigen Bereichen von Materialien A und B beschichtet ist, wobei A ein Lotmaterial und B ein dielektrisches Material ist, wobei die Fläche jeder Orthogonalprojektion des gesamten Verbinders mindestens 10% größer ist als die Fläche der Orthogonalprojektion von jedem der Bereiche von Material A.

2. Verbinder gemäß Anspruch 1, wobei die Fläche der Orthogonalprojektion des Verbinders mindestens 25% und höchstens 80% größer ist als die Fläche der Orthogonalprojektion von jedem der Bereiche von Material A.

3. Verbinder gemäß einem der Ansprüche 1 oder 2, wobei die Orthogonalprojektion von jedem der Bereiche von Material A gleich weit von den Rändern der Orthogonalprojektion des gesamten Verbinders entfernt ist.

4. Verbinder gemäß einem der Ansprüche 1 - 3, wobei die Leiterstruktur ein Band oder ein Draht ist.

5. Verbinder gemäß einem der Ansprüche 1 - 4, wobei die Leiterstruktur Kupfer enthält oder aus Kupfer besteht.

6. Verbinder gemäß einem der Ansprüche 1 - 5, wobei das dielektrische Material B Füllstoff aufweist, der ausgewählt ist aus der Gruppe bestehend aus dielektrischen Materialien und metallischen Materialien.

7. Verbinder gemäß Anspruch 6, wobei der Füllstoff ein Metalloxidpulver ist.

8. Verbinder gemäß einem der Ansprüche 1 - 7, wobei das Material B ein Polymermaterial aufweist.

9. Verbinder gemäß einem der Ansprüche 1 - 8, wobei das Material B ein Elastizitätsmodul von 7 GPa oder weniger aufweist.

10. Verfahren zur Herstellung eines Verbinders gemäß einem der Ansprüche 1 - 9, geeignet zum Verbinden einer ersten Solarzellenelektrode mit einem weiteren Element, umfassend die Schritte:
d) Bereitstellen einer metallischen Leiterstruktur,
e) teilweises Beschichten der metallischen Leiterstruktur entlang des Hauptachse mit zwei voneinander getrennten Bereichen, mit einem dielektrische Material B, und
f) teilweises Beschichten der metallischen Leiterstruktur entlang des Hauptachse mit zwei voneinander getrennten Bereichen entlang des Umfangs, mit einem Lotmaterial A,
wobei das teilweise Beschichten der Materialien A und B jeweils so erfolgt, dass die metallische Leiterstruktur entlang des Umfangs abwechselnd mit diesen Materialien beschichtet wird.

11. Verfahren gemäß Anspruch 10, wobei die Leiterstruktur zuerst mit Material B beschichtet wird.

12. Verfahren gemäß einem der Ansprüche 10 oder 11, wobei, das teilweise Beschichten mit Material B durch Drucken erfolgt.

13. Verfahren gemäß einem der Ansprüche 10 - 12, **dadurch gekennzeichnet, dass** Schritt c) durch Eintauchen der Leiterstruktur in eine flüssige Lotlegierung erfolgt.

14. Photovoltaikbauteil umfassend eine erste Solarzellenelektrode und ein weiteres Element, wobei die Solarzellenelektrode und das weitere Element durch einen Verbinder gemäß einem der Ansprüche 1 - 9 miteinander verbundenen sind.

15. Photovoltaikbauteil gemäß Anspruch 14, wobei das weitere Element eine weitere Solarzellenelektrode ist.

16. Photovoltaikbauteil gemäß Anspruch 14 oder 15, wobei die erste Solarzellenelektrode eine Frontseitenelektrode ist und das weitere Element eine Rückseitenelektrode ist.

## Claims

1. Connector for connecting a first solar cell electrode to a further element, wherein the connector has a metallic conductor structure and the conductor structure is alternately coated circumferentially along its circumference with two continuous regions each of materials A and B, wherein A is a solder material and B is a dielectric material, wherein the area of each orthogonal projection of the entire connector is at least 10% greater than the area of the orthogonal projection of each of the regions of material A.

2. Connector according to claim 1, wherein the area of the orthogonal projection of the connector is at least 25% and at most 80% greater than the area of the orthogonal projection of each of the regions of material A.

3. Connector according to either of claims 1 or 2, wherein the orthogonal projection of each of the regions of material A is the same distance from the edges of the orthogonal projection of the entire connector.

4. Connector according to any of claims 1 to 3, wherein the conductor structure is a ribbon or wire.

5. Connector according to any of claims 1 to 4, wherein the conductor structure contains copper or consists of copper.

6. Connector according to any of claims 1 to 5, wherein the dielectric material B comprises filler selected from the group consisting of dielectric materials and metallic materials.

7. Connector according to claim 6, wherein the filler is a metal oxide powder.

8. Connector according to any of claims 1 to 7, wherein the material B comprises a polymer material.

9. Connector according to any of claims 1 to 8, wherein the material B has a modulus of elasticity of 7 GPa or less.

10. Method for producing a connector according to any of claims 1 to 9, suitable for connecting a first solar cell electrode to a further element, comprising the steps of:
d) providing a metallic conductor structure,
e) partially coating the metallic conductor structure with a dielectric material B along the main axis with two regions separated from one another, and
f) partially coating the metallic conductor structure with a solder material A along the main axis with two regions separated from one another along the circumference,
wherein the partial coating with materials A and B is in each case carried out in such a way that the metallic conductor structure is alternately coated with these materials along the circumference.

11. Method according to claim 10, wherein the conductor structure is first coated with material B.

12. Method according to either of claims 10 or 11, wherein the partial coating with material B is carried out by printing.

13. Method according to any of claims 10 to 12, **characterized in that** step c) takes place by immersing the conductor structure in a liquid solder alloy.

14. Photovoltaic component comprising a first solar cell electrode and a further element, wherein the solar cell electrode and the further element are connected together by a connector according to any of claims 1 to 9.

15. Photovoltaic component according to claim 14, wherein the further element is a further solar cell electrode.

16. Photovoltaic device according to either claim 14 or claim 15, wherein the first solar cell electrode is a front-side electrode and the further element is a rear-side electrode.

## Revendications

1. Connecteur pour la connexion d'une première électrode de cellule solaire à un autre élément, dans lequel le connecteur présente une structure à conducteur métallique et la structure à conducteur est revêtue par deux zones continues de matériaux A et B qui l'entourent alternativement le long de sa circonférence, dans lequel A est un matériau de brasage et B un matériau diélectrique, dans lequel la surface de chaque projection orthogonale du connecteur complet est au moins 10 % plus grande que la surface de la projection orthogonale de chacune des zones de matériau A.

2. Connecteur selon la revendication 1, dans lequel la surface de la projection orthogonale du connecteur est au moins 25 % et au plus 80 % plus grande que la surface de la projection orthogonale de chacune des zones de matériau A.

3. Connecteur selon l'une quelconque des revendications 1 ou 2, dans lequel la projection orthogonale de chacune des zones de matériau A se trouve à la même distance des bords de la projection orthogonale du connecteur complet.

4. Connecteur selon l'une quelconque des revendications 1 à 3, dans lequel la structure à conducteur est une bande ou un fil.

5. Connecteur selon l'une quelconque des revendications 1 à 4, dans lequel la structure à conducteur contient du cuivre ou se compose de cuivre.

6. Connecteur selon l'une quelconque des revendications 1 à 5, dans lequel le matériau diélectrique B présente une matière de remplissage, qui est choisie dans le groupe composé de matériaux diélectriques et de matériaux métalliques.

7. Connecteur selon la revendication 6, dans lequel la matière de remplissage est une poudre d'oxyde métallique.

8. Connecteur selon l'une quelconque des revendications 1 à 7, dans lequel le matériau B présente un matériau polymère.

9. Connecteur selon l'une quelconque des revendications 1 à 8, dans lequel le matériau B présente un module élastique de 7 GPa ou moins.

10. Procédé de fabrication d'un connecteur selon l'une quelconque des revendications 1 à 9, approprié pour la connexion d'une première électrode de cellule solaire avec un autre élément, comprenant les étapes de :
d) fourniture d'une structure à conducteur métallique,
e) revêtement partiel de la structure à conducteur métallique le long de l'axe principal comprenant deux zones séparées l'une de l'autre, avec un matériau diélectrique B, et
f) revêtement partiel de la structure à conducteur métallique le long de l'axe principal comprenant deux zones séparées l'une de l'autre, avec un matériau de brasage A,
dans lequel le revêtement partiel des matériaux A et B est effectué respectivement de telle façon que la structure à conducteur métallique est revêtue alternativement par ces matériaux le long de la circonférence.

11. Procédé selon la revendication 10, dans lequel la structure à conducteur est revêtue en premier avec le matériau B.

12. Procédé selon l'une quelconque des revendications 10 ou 11, dans lequel le revêtement partiel avec le matériau B est effectué par pression.

13. Procédé selon l'une quelconque des revendications 10 à 12, **caractérisé en ce que** l'étape c) est effectuée par l'immersion de la structure à conducteur dans un alliage de brasure liquide.

14. Composant photovoltaïque comprenant une première électrode de cellule solaire et un autre élément, l'électrode de cellule solaire et l'autre élément étant connectés entre eux par un connecteur selon l'une quelconque des revendications 1 à 9.

15. Composant photovoltaïque selon la revendication 14, dans lequel l'autre élément est une autre électrode de cellule solaire.

16. Composant photovoltaïque selon la revendication 14 ou 15, dans lequel la première électrode de cellule solaire est une électrode de côté avant et l'autre élément est une électrode de côté arrière.
